# DEMANDE DE BREVET EUROPEEN

(11) **EP 0 577 497 A1**
(43) Date de publication de la demande: **05.01.1994**
(21) Numéro de dépôt: 93401672.6
(22) Date de dépôt: 29.06.1993
(51) Int. Cl.: H01L 29/808, H01L 29/73, H01L 21/337

(54) **Transistor JFET vertical à capacité grille/substrat réduite, et procédé de fabrication correspondant**

(30) Priorité: 02.07.1992 FR 9208178
(71) Demandeur: FRANCE TELECOM, F-75015 Paris (FR)
(72) Inventeur: Chantre, Alain, F-38120 Saint-Egrève (FR)
(74) Mandataire: Casalonga, Axel

(57) **Abrégé**

Le transistor à effet de champ comporte une couche isolante (3) disposée à l'extérieur de la région de canal (7) entre la grille (4) et le substrat (1, 2).

## Description

L'invention concerne les structures semi-conductrices susceptibles de former un transistor à effet de champ vertical à jonction, capable en outre de fonctionnement bipolaire.

Un transistor classique à effet de champ vertical à jonction, ou plus simplement transistor JFET vertical, comporte, en raison du procédé de fabrication généralement employé, une région de grille implantée au sein d'un substrat semi-conducteur. Le substrat possède un premier type de conductivité (N dans le cas d'un transistor JFET à canal N) tandis que la région de grille a le type de conductivité opposé (P dans le cas présent). Le substrat incorpore au moins en partie, la région de canal, et, dans sa partie inférieure la région de drain. La jonction PN ainsi formée entre la grille et le substrat, crée des capacités parasites qui peuvent s'avérer gênantes dans certaines applications.

On ne connaît pas actuellement de solution permettant de minimiser, voire de s'affranchir, de ces capacités parasites grille/substrat.

L'invention vise à apporter une solution à ce problème.

Elle a pour but de proposer un tel transistor qui soit simple à réaliser.

L'invention a donc pour objet un transistor à effet de champ vertical à jonction, comprenant une structure semi-conductrice comportant une couche isolante disposée à l'extérieur de la région de canal entre la grille et le substrat.

Selon un mode de réalisation de l'invention, la structure semi-conductrice comprend une région intermédiaire, susceptible de former la région de canal, ayant un premier type de conductivité, surrnontant une première région susceptible de former la région de drain, incluse dans le substrat, ayant également le premier type de conductivité et avantageusement surdopée par rapport à la région intermédiaire. Cette région intermédiaire possède une partie saillante surmontée d'une deuxième région, susceptible de former la région de source, ayant également le premier type de conductivité et avantageusement surdopée par rapport à la région intermédiaire. Cette structure semiconductrice comprend également une troisième région, susceptible de former la région de grille, ayant le type de conductivité opposé, avantageusement surdopée, disposée de part et d'autre d'une partie de la région intermédiaire, et séparée, d'une part, de la deuxième région par une séparation isolante, ou espaceurs, disposée autour de la partie saillante et, d'autre part, du substrat par ladite couche isolante disposée autour de la partie inférieure de la région intermédiaire.

Cette couche isolante a avantageusement une épaisseur au moins égale à la largeur de la zone de charge d'espace d'une jonction PN qui serait réalisée à partir du matériau semi-conducteur de base du transistor à effet de champ. Elle peut être comprise entre environ 0,2 µm et environ 1 µm, de préférence de l'ordre de 0,5 µm.

Lorsque le transistor est réalisé à base de silicium, les régions de canal, de source et de drain comportent avantageusement du silicium monocristallin, tandis que la couche isolante est du dioxyde de silicium et que la région de grille comporte du silicium polycristallin.

Afin de minimiser les capacités parasites drain/substrat, il est particulièrement avantageux de prévoir un substrat sur isolant.

Un tel transistor peut être utilisé dans un mode de fonctionnement bipolaire; dans ce cas, la région de drain constitue la région de collecteur, la région de source, celle de l'émetteur, et la région de grille, celle de la base.

L'invention a également pour objet un procédé de fabrication d'une structure semi-conductrice susceptible de former un transistor à jonction, à effet de champ ou bipolaire; selon une caractéristique générale de l'invention,
a) on forme sur un substrat semi-conducteur contenant une première région ayant un premier type de conductivité, un empilement comportant une couche d'un matériau semi-conducteur ayant un type de conductivité opposé au premier, encadrée par deux couches de matériaux isolants,
b) on réalise dans cet empilement, un orifice principal s'étendant jusqu'à la première région,
c) on forme dans cet orifice principal, une région intermédiaire, à partir d'un matériau semi-conducteur, ayant le premier type de conductivité, et une deuxième région surmontant cette région intermédiaire, ayant également le premier type de conductivité,
d) on découvre la face supérieure de la couche semi-conductrice de l'empilement dans une région située à distance et à l'extérieur de la région de canal, et
e) on réalise des métallisations sur une partie au moins de la première et de la deuxième régions, ainsi que sur une partie au moins de la couche semi-conductrice de l'empilement, découverte.

Il est particulièrement avantageux, de surdoper les première et deuxième régions ainsi que la couche semi-conductrice de l'empilement, afin d'obtenir un meilleur contact électrique avec les différentes métallisations, notamment dans le cas où la structure semiconductrice est réalisée à base de silicium.

Selon un mode de mise en oeuvre du procédé, la formation de la région intermédiaire et de la deuxième région, comporte un dépôt par épitaxie, par exemple un dépôt par épitaxie sélective à l'intérieur de l'orifice principal.

La face supérieure de la couche semi-conductrice de l'empilement peut être découverte à partir d'une opération de gravure, telle qu'une opération de gravure ionique réactive.

Afin de réaliser un accès à la première région susceptible de former le drain, on retire la couche semi-conductrice déposée sur la première couche isolante en contact avec le substrat, dans une zone auxiliaire prédéterminée située à distance de celle dans laquelle sera réalisé ledit orifice principal; on dépose ensuite la deuxième couche isolante de l'empilement, on réalise dans cette zone auxiliaire un orifice auxiliaire s'étendant jusqu'à la première région du substrat, et on forme dans cet orifice auxiliaire une région de contact ayant le même type de dopage que celui de la première région.

D'autres avantages et caractéristiques de l'invention apparaîtront à l'examen de la description détaillée ci-après et des dessins annexés sur lesquels :
la figure 1 est une coupe schématique d'un transistor JFET selon l'invention;
les figures 2 à 5 illustrent différentes étapes du procédé de fabrication selon l'invention; et
la figure 6 illustre un autre type de substrat utilisé pour la fabrication d'un tel transistor.

On va maintenant décrire la structure et le procédé de fabrication d'un transistor JFET vertical à canal N, bien que l'invention puisse s'appliquer à un transistor JFET à canal P, en inversant tous les types de dopants par rapport à ce qui va être maintenant décrit.

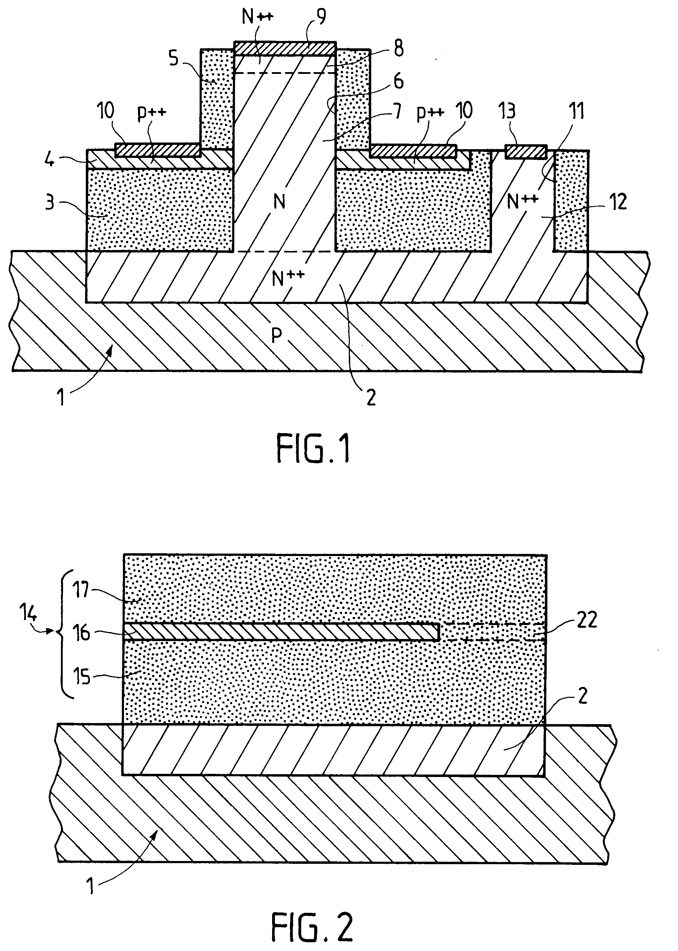

Sur la figure 1, la référence 1 désigne un substrat massif de silicium dopé selon le type de conductivité P (conduction par trous). Dans ce substrat est implantée une première région 2 ayant le type de conductivité opposé, c'est-à-dire N (conduction par électrons). Cette première région est surdopée, par exemple avec une concentration d'électrons de l'ordre de 10²⁰ cm⁻³, par rapport à une région 7 de silicium N dans laquelle est susceptible de se former le canal du transistor à jonction. La concentration d'électrons dans les régions dopées N est de l'ordre de 10¹⁷ cm⁻³. Cette région intermédiaire, dite de canal, 7 est surmontée par une deuxième région 8, ayant aussi le type de conductivité N et également surdopée par rapport à la région de canal, sur laquelle est prévue une métallisation 9.

Les régions 7 et 8 du transistor JFET sont situées (au moins en partie) à l'intérieur d'un orifice principal 6 ménagé au sein d'un empilement comportant une couche semi-conductrice 4, formée de silicium polycristallin surdopé, ayant une épaisseur de l'ordre de 1000 à 2000 Å et un type de conductivité opposé à celui de la région de canal, c'est-à-dire ici le type P. Sous cette couche semi-conductrice 4, se trouve une première couche isolante 3, sensiblement parallèle à la face supérieure du substrat 1, et s'étendant jusqu'à ce dernier, à l'extérieur de la partie inférieure de la région de canal 7. Cette première couche isolante est réalisée par exemple à partir de dioxyde de silicium et a une épaisseur de l'ordre de 0,5 à 0,7 µm.

Autour de la partie supérieure saillante de la structure incorporant une partie de la région de canal 7 ainsi que la deuxième région 8, sont prévus des espaceurs isolants 5 réalisés également par exemple en dioxyde de silicium. Ces espaceurs ont notamment pour fonction de séparer la deuxième région 8 de la région 4 sur laquelle est prévue également une métallisation 10 s'étendant jusqu'aux espaceurs 5.

Un orifice auxiliaire 11 est ménagé dans une zone auxiliaire du transistor, située à distance de celle dans laquelle se trouve l'orifice principal 6. Cet orifice auxiliaire est rempli par du silicium de type N surdopé, formant une région 12 venant au contact, dans sa partie inférieure, avec la région enterrée 2, et surmontée d'une métallisation 13. On remarquera ici que l'extrémité de la couche semi-conductrice 4 se situe à distance de la région de conductivité opposée 12 contenue dans l'orifice 11.

Lorsque cette structure semi-conductrice est utilisée en tant que transistor à effet de champ à jonction, la couche semi-conductrice 4 constitue la région de grille avec le contact de grille 10, la région surdopée 8 forme la région de source avec le contact de source 9, tandis que la partie de la région 2. située sous la région de canal 7, forme le drain du transistor relié au contact de drain 13 par la région 12 contenue dans l'orifice auxiliaire 11.

Le diamètre de l'orifice 6 a été pris inférieur à 1 µm environ, ce qui permet dans ce mode de réalisation, compte tenu du dopage utilisé, d'avoir un recouvrement significatif des zones de charge d'espace des jonctions grille/source en présence d'une tension de polarisation grille/source V_{GS} nulle, afin d'assurer le bloquage du transistor (transistor normalement fermé : "Normally OFF"). Bien entendu, l'homme du métier comprendra que l'on peut ajuster le diamètre de l'orifice à différentes valeurs, en fonction du matériau utilisé et de son dopage pour obtenir la condition de bloquage à V_{GS} nulle. Par ailleurs, on peut envisager de réaliser dans certaines applications un transistor normalement ouvert ("Normally ON"). L'homme du métier saura ajuster alors le diamètre de l'orifice 6.

Un tel transistor peut être également utilisé en fonctionnement bipolaire. Dans ce cas, les régions de drain, source et grille du transistor à effet de champ, constituent respectivement les régions de collecteur, émetteur et base du transistor bipolaire. Bien entendu, l'utilisation de ce transistor JFET à canal N dans le mode de fonctionnement bipolaire nécessite de polariser en direct la région de grille par rapport à la région de source, c'est-à-dire de prévoir une tension grille/source supérieure à environ 0,7 Volt.

Ce transistor a été réalisé sur un substrat massif de type P, ce qui permet notamment d'isoler plusieurs transistors du même type réalisés à partir de la même plaquette de silicium de type P. Bien entendu, on aurait pu réaliser ce transistor à partir d'un substrat de silicium massif de type N, dans lequel aurait été implantée la région surdopée 2.

Par ailleurs, les régions de drain, source et de grille ont été ici surdopées afin d'obtenir un meilleur contact électrique entre le métal et le silicium utilisé comme semi-conducteur de base. Néanmoins, il est possible de s'affranchir d'un tel surdopage de ces régions si l'on utilise un matériau semi-conducteur permettant d'obtenir directement un contact satisfaisant avec les métallisations. De tels matériaux existent parmi les matériaux III-V, c'est-à-dire des matériaux comportant en parts égales un élément de la troisième colonne et un élément de la cinquième colonne de la classification périodique de Mendeléeff.

D'une façon générale, la largeur de la première couche isolante 3 située sous la grille à l'extérieur de la région de la zone de canal, peut être prise égale à la largeur de la zone de charge d'espace de la jonction PN existant entre la zone de grille et le substrat dans les transistors JFET verticaux classiques. En effet, la capacité parasite grille/substrat sera déjà réduite grâce à la faible constante diélectrique de l'isolant. On utilisera donc généralement une épaisseur minimale de couche isolante de l'ordre de 0,2 µm.

En ce qui concerne la valeur maximale de cette épaisseur, on ne dépassera pas généralement la valeur de 1 µm de façon à ne pas avoir une résistance verticale d'accès au drain trop importante.

On va maintenant décrire en détail le procédé de fabrication du transistor de la figure 1 en se référant plus particulièrement aux figures 2 à 5.

La première étape de ce procédé consiste à déposer sur le substrat 1 (figure 2) dans laquelle a été implantée la région 2 de type N surdopée, un empilement 14 constitué d'une première couche d'isolant 15 surmontée d'une couche semi-conductrice 16 d'un type de conductivité opposé à celle de la région 2, elle-même surmontée d'une deuxième couche d'isolant 17.

Concrètement, on dépose tout d'abord sur le substrat 1, d'une façon classique, la couche d'isolant 15 constituée ici de dioxyde de silicium. On dépose ensuite du silicium polycristallin que l'on surdope pour lui conférer le type de conductivité P, et l'on dépose ensuite sur ce silicium polycristallin la deuxième couche d'isolant 17 constituée ici également de dioxyde de silicium.

Dans le cas où l'on souhaite réaliser le contact de drain sur la face avant du transistor, on retire, avant d'effectuer le dépôt de la deuxième couche d'isolant 17, une partie de la couche semi-conductrice 16, par exemple par gravure ionique réactive, dans une zone auxiliaire 22.

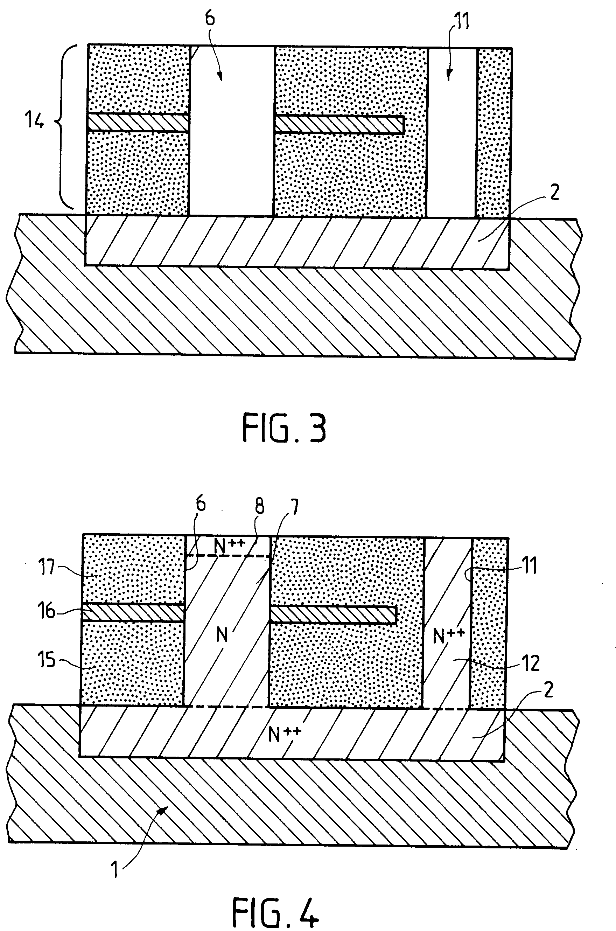

Dans cet empilement 14, on réalise ensuite (figure 3) l'orifice principal 6, par exemple par gravure ionique réactive, et éventuellement l'orifice auxiliaire 11 dans la zone 22 exempte de silicium polycristallin 16. Ces orifices s'étendent jusqu'à la région surdopée 2. On notera ici que l'épaisseur maximale de 1 µm adoptée pour ne pas conférer une résistance verticale d'accès au drain trop importante, reste compatible avec la réalisation selon les techniques classiques, d'un orifice 6 ayant un diamètre submicronique.

L'étape suivante consiste à former dans l'orifice 6 la région de canal 7 et la région 8. A cet effet, on fait croître par épitaxie sélective dans l'orifice 6 du silicium de type N jusqu'à la face supérieure de l'empilement et l'on effectue une implantation ionique de phosphore ou d'Arsenic par exemple, afin d'obtenir le surdopage de la région 8. On effectue également une épitaxie sélective dans l'orifice auxiliaire 11 suivie d'une implantation de phosphore de façon à obtenir la région 12.

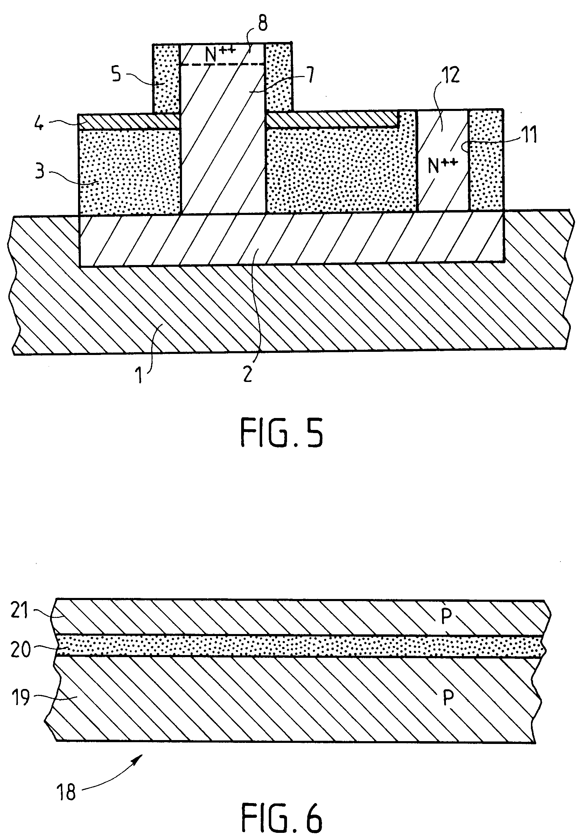

L'étape suivante (illustrée sur la figure 5) consiste à découvrir la face supérieure de la couche semi-conductrice 4 de l'empilement, dans une région située à distance autour de la région de canal 7, de façon à réaliser les espaceurs 5 d'épaisseur choisie. Le reste de l'empilement, situé dans la zone auxiliaire de l'orifice auxiliaire 11, a été de préférence arrasé dans le même plan que celui contenant la face supérieure de la couche semi-conductrice 4.

L'étape finale de ce procédé consiste à réaliser les métallisations 9, 10 et 13 par une technique connue du type salicide "self aligned silicide", qui comporte le dépôt d'une couche de métal (par exemple du titane) pour former un siliciure sur les zones de silicium semiconductrices (TiSi₂).

Bien qu'il ait été utilisé ici une épitaxie sélective pour former les régions semi-conductrices à l'intérieur des orifices 6 et 11 du transistor, on aurait pu utiliser une simple épitaxie sur l'ensemble de l'empilement percé de ces orifices, suivie d'une étape de gravure afin d'éliminer les dépôts semi-conducteurs superflus.

De même, bien qu'il soit préférable d'effectuer l'opération de formation des espaceurs par gravure, après l'étape d'épitaxie sélective à l'intérieur de l'orifice 6, on pourrait concevoir de réaliser d'abord les espaceurs 5, puis d'effectuer l'épitaxie sélective à l'intérieur de l'orifice 6.

Il convient également de remarquer que la localisation des régions de source (émetteur) et de grille (base) dans des plans horizontaux différents permet d'auto-aligner ces régions, c'est-à-dire de ne pas utiliser de masque spécifique pour la réalisation de la grille par rapport à celui utilisé pour la réalisation de la source. Ceci permet d'obtenir également, dans certaines applications, une largeur de canal submicronique et des performances en fréquence améliorées.

Bien que l'invention trouve ses pleins avantages dans le mode de réalisation décrit ci-dessus, il s'avère encore préférable d'utiliser dans certaines applications, un substrat sur isolant, au lieu d'un substrat massif, afin de minimiser les capacités parasites drain/substrat ou collecteur/substrat. Un tel substrat sur isolant 18 est illustré schématiquement sur la figure 6. Il comporte une région inférieure de silicium 19 surmontée d'une couche isolante 20 de dioxyde de silicium, elle-même surmontée d'une autre couche de silicium 21, de type P ou N, jouant le rôle du substrat 1 illustré sur les figures 1 à 5.

L'homme du métier connaît de tels substrats sous la dénomination SOI (Silicon on insulator).

## Revendications

1. Transistor à effet de champ vertical à jonction, caractérisé par le fait qu'il comprend une structure semi-conductrice comportant une couche isolante (3) disposée à l'extérieur de la région de canal (7) entre la grille (4) et le substrat (1, 2), et séparant totalement la grille du substrat.

2. Transistor selon la revendication 1, caractérisé par le fait que la structure semi-conductrice comprend :
- une région intermédiaire (7), susceptible de former la région de canal, ayant un premier type de conductivité (N), surmontant une première région (2), susceptible de former la région de drain, incluse dans le substrat (1), ayant également le premier type de conductivité (N⁺⁺),
- une partie saillante, incorporant une partie de la région de canal (7) et une deuxième région (8) surmontant la région de canal, susceptible de former la région de source, ayant également le premier type de conductivité (N⁺⁺),
- une troisième région (4), susceptible de former la région de grille, ayant le type de conductivité opposé (P⁺⁺), disposée de part et d'autre d'une partie de la région de canal (7), et séparée d'une part de la deuxième région (8) par une séparation isolante (5) disposée autour de la partie saillante et, d'autre part, du substrat (1, 2) par ladite couche isolante (3) disposée à l'extérieur de la région de canal (7).

3. Transistor selon la revendication 1 ou 2, caractérisé par le fait que la couche isolante (3) a une épaisseur au moins égale à la largeur de la zone de charge d'espace d'une jonction P-N réalisée à partir du matériau semi-conducteur de base du transistor à effet de champ.

4. Transistor selon l'une des revendications précédentes, caractérisé par le fait que la couche isolante (3) a une épaisseur comprise entre environ 0,2 µm et environ 1 µm, de préférence de l'ordre de 0,5 µm.

5. Transistor selon l'une des revendications précédentes, caractérisé par le fait que les régions de canal, de source et de drain comportent du silicium mono-cristallin, tandis que la couche isolante comporte du dioxyde de silicium et que la région de grille comporte du silicium polycristallin.

6. Transistor selon l'une des revendications précédentes, caractérisé par le fait que les régions de drain (2), de source (8) et de grille (4) sont surdopées.

7. Transistor selon l'une des revendications précédentes, caractérisé par le fait que le substrat est un substrat sur isolant (18).

8. Transistor selon l'une des revendications 1 à 6, pour son utilisation dans un mode de fonctionnement bipolaire, caractérisé par le fait que les régions de drain, source et grille constituent respectivement les régions de collecteur, émetteur et base du transistor bipolaire correspondant.

9. Transistor selon l'une des revendications précédentes, caractérisé par le fait que les régions de source ou d'émetteur d'une part, et de grille ou base d'autre part, sont situées dans des plans horizontaux différents.

10. Procédé de fabrication d'une structure semi-conductrice, susceptible de former un transistor à jonction, à effet de champ ou bipolaire, caractérisé par le fait que :
a) on forme sur un substrat semi-conducteur (1, 18) contenant une première région (2) ayant un premier type de conductivité, un empilement (14) comportant une couche (16) d'un matériau semiconducteur, ayant un type de conductivité opposé au premier type, encadrée par deux couches (15, 17) de matériaux isolants,
b) on réalise dans l'empilement un orifice principal (6) s'étendant jusqu'à la première région (2),
c) on forme dans l'orifice principal (6) une région intermédiaire (7) à partir d'un matériau semi-conducteur, ayant le premier type de conductivité, ainsi qu'une deuxième région (8) au-dessus de la région intermédiaire, ayant également le premier type de conductivité,
d) on découvre la face supérieure de la couche semi-conductrice (16) de l'empilement (14) dans une région située à distance autour de la région intermédiaire (7), et
e) on réalise des métallisations (9, 10, 13) sur une partie au moins de la première et de la deuxième régions (2, 8), ainsi que sur une partie au moins de la couche semi-conductrice de l'empilement (4), découverte.

11. Procédé selon la revendication 10, caractérisé par le fait que la formation des première et deuxième régions ainsi que la formation de la couche semi-conductrice de l'empilement, comportent un surdopage.

12. Procédé selon la revendication 10 ou 11, caractérisé par le fait que la formation de la région intermédiaire et de la deuxième région comprend un dépôt par épitaxie.

13. Procédé selon la revendication 12, caractérisé par le fait que le dépôt par épitaxie est un dépôt par épitaxie sélective à l'intérieur de l'orifice principal.

14. Procédé selon l'une des revendications 10 à 13, caractérisé par le fait que l'étape de formation de l'orifice principal (6) ainsi que l'étape d) comprennent une opération de gravure.

15. Procédé selon l'une des revendications 10 à 14, caractérisé par le fait que, dans l'étape a), on dépose la couche semi-conductrice (16) sur la première couche isolante (15), puis on retire la partie de cette couche semi-conductrice (16) dans une zone auxiliaire située à distance de celle dans laquelle sera aménagé ledit orifice principal (6), et on dépose ensuite la deuxième couche isolante (17),
par le fait que l'on réalise dans l'empilement un orifice auxiliaire (11) dans ladite zone auxiliaire s'étendant jusqu'à la première région (2),
par le fait que l'on forme dans cet orifice auxiliaire (11) une région (12), de préférence surdopée, ayant le même type de conductivité que la première région (2),
et l'on réalise une métallisation (13) sur la face supérieure de la région semi-conductrice (12) contenue dans l'orifice auxiliaire (11).
